# EUROPEAN PATENT APPLICATION

(11) **EP 4 223 849 A1**
(43) Date of publication of application: **09.08.2023**
(21) Application number: 21875422.4
(22) Date of filing: 24.09.2021
(51) Int. Cl.: C09G 1/02, C09K 3/14, B24B 37/00, H01L 21/304

(54) **CERIUM OXIDE AND POLISHING AGENT**

(30) Priority: 30.09.2020 JP 2020164640
(71) Applicant: AGC INC., Chiyoda-ku, Tokyo 1008405 (JP)
(72) Inventor: SHIBUYA, Tomohiro, Tokyo 100-8405 (JP); OKAMURA, Yuzo, Tokyo 100-8405 (JP); YAMADA, Taku, Tokyo 100-8405 (JP)
(74) Representative: Müller-Boré & Partner Patentanwälte PartG mbB
(86) International application number: PCT/JP2021/035109
(87) International publication number: WO 2022/071120

(57) **Abstract**

Provided are a cerium oxide and a polishing agent capable of high-speed polishing on a silicon nitride film. The cerium oxide has a CO₂ desorption amount obtained through a temperature programmed desorption measurement of CO₂ performed with use of oxygen and carbon monoxide that satisfies one or more selected from (A) to (D) below. (A): In the CO-TPD, the cerium oxide has at least one peak of a CO₂ desorption amount within a range of 700°C or higher. (B): In the CO-TPD, the cerium oxide has a total desorption amount of CO₂ of no smaller than 35 µmol/g. (C): In the CO-TPD, the cerium oxide has a ratio (S/T) of a total desorption amount (S) of CO₂ in a temperature range of 600°C or higher to a total desorption amount (T) of CO₂ of no lower than 0.3 (D): The cerium oxide is a particle having a true density of 5.0-6.8 g/cm³.

## Description

### Technical Field

The present invention relates to cerium oxides and polishing agents.

### Background Art

The recent trend toward a higher degree of integration or higher functionality of semiconductor integrated circuits is propelling development in microfabrication techniques that achieve smaller, denser semiconductor elements. Conventionally, in the manufacture of semiconductor integrated circuit devices (also referred to below as semiconductor devices), interlayer insulating films, buried wirings, or the like are flattened with use of chemical mechanical polishing (hereinafter, CMP) so as to prevent such problems as that sufficient resolution cannot be obtained as the unevenness (steps) in a layer surface exceeds the depth of focus in lithography. Importance of further flattening with use of CMP is on the rise as the demands for higher-definition, smaller elements become severer.

Furthermore, in the manufacture of semiconductor devices in recent years, a method of isolation with a shallow trench with a small element isolation width (Shallow Trench Isolation: hereinafter, STI) is adopted in order to advance even higher shrinkage of semiconductor elements.

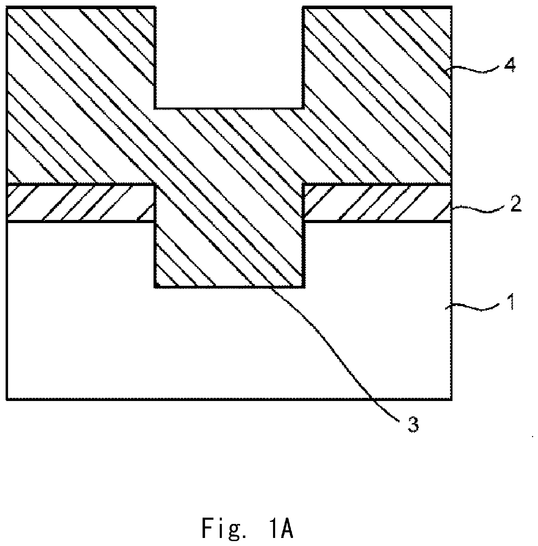

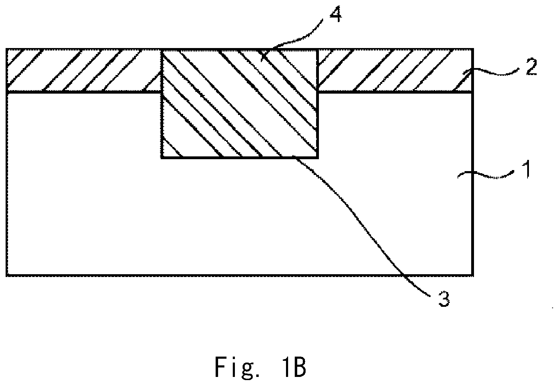

In this technique called STI, a trench (groove) is formed in a silicon substrate, and the trench is filled with an insulating film. Thus, element regions that are electrically insulated are formed. One example of STI will be described with reference to Figs. 1A and 1B. As illustrated in FIG. 1A, an element region of a silicon substrate 1 is masked with a silicon nitride film 2 or the like. Then, a trench 3 is formed in the silicon substrate 1, and an insulating layer, such as a silicon dioxide film 4, is deposited to fill the trench 3. Next, the silicon dioxide film 4 on the silicon nitride film 2, which defines a protruding portion, is polished to be removed through CMP, with the silicon dioxide film 4 in the trench 3, which defines a recessed portion, remaining. Thus, an element isolation structure in which the trench 3 is filled with the silicon dioxide film 4, as illustrated in Fig. 1B, is obtained.

Polishing agents that contain cerium oxide particles are known as a type of polishing agents for CMP.

Patent Literature 1, for example, discloses a polishing agent that contains a specific water-soluble polymer, cerium oxide particles, and water and that has a pH of 4-9. With this polishing agent disclosed in Patent Literature 1, the polishing speed on a silicon nitride film can be kept low while maintaining a high polishing speed on a silicon oxide film. In the example shown in Figs. 1A and 1B, the silicon nitride film 2 serves as a polishing stopper film, and thus a favorable flat surface can be obtained.

Separately from the above, Patent Literature 2 discloses, as a method of preparing a metal-doped cerium composition that excels in thermal stability and is used in, for example, a catalyst for processing exhaust gas, a specific method that includes, in the presence of nitric acid ions, preparing a solution containing a cerium (III) salt, cerium (IV), and a salt of a metal; forming a precipitate by bringing this solution into contact with a base; and subjecting this precipitate to heat treatment.

Non Patent Literature 1 discloses a method of synthesizing, with a hydrothermal synthesis technique, a hexahedral cerium oxide whose 100 plane is exposed.

Meanwhile, Non Patent Literature 2 illustrates a temperature programmed desorption (CO-TPD) measurement technique as a technique for examining the redox characteristics of a catalyst on a cerium oxide crystal surface. CO-TPD is a technique for evaluating the desorption temperature and the adsorption amount held when carbon dioxide (CO₂) formed from oxygen (O) on the surface of cerium oxide and carbon monoxide (CO) that is adsorbed on this surface is desorbed from the surface of an oxide.

### Citation list

### Patent Literature

Patent Literature 1: Japanese Unexamined Patent Application Publication No. 2019-87660
Patent Literature 2: Japanese Unexamined Patent Application Publication No. 2017-529296

### Non Patent Literature

Non Patent Literature 1: Zili Wu et al., Langmuir 2010, 26(21), 16595-16606.
Non Patent Literature 2: Wu, Z., Li, M., & Overbury, S. H. (2012). On the structure dependence of CO oxidation over CeO2 nanocrystals with well-defined surface planes. Journal of catalysis, 285(1), 61-73.

### Summary of Invention

### Technical Problem

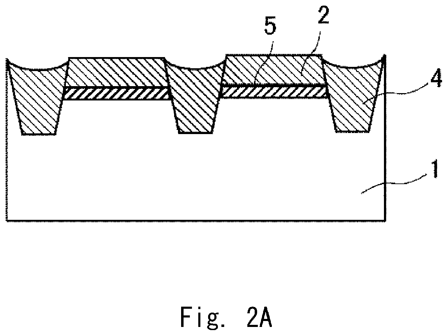

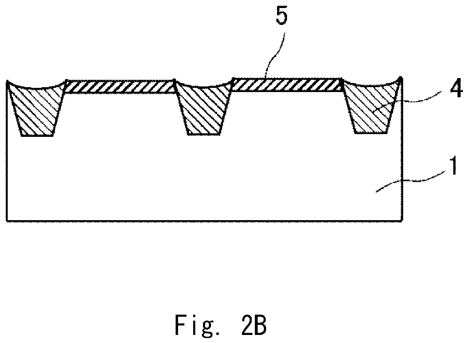

Another example of STI, separate from the one shown in Figs. 1A and 1B, will be described with reference to Figs. 2A and 2B. As illustrated in Fig. 2A, this example differs from the one shown in Fig. 1A in that a titanium nitride film 5 and a silicon nitride film 2 are stacked in this order over an element region of a silicon substrate 1. In the example shown in Fig. 2A, the silicon nitride film 2, along with a silicon oxide film 4, needs to be polished to be removed, as illustrated in Fig. 2B.

In this respect, a typical use of conventional polishing agents containing cerium oxide particles is to polish a silicon oxide film at a high speed and to keep the polishing speed on a silicon nitride film low, and such conventional polishing agents are not to polish a silicon oxide film and a silicon nitride film simultaneously at a high speed.

In one conceivable method, an additive that works on a silicon oxide film of a high polishing speed may be added, and thus polishing of the silicon oxide film can be slowed to equalize the speeds. However, such a method poses a problem that faster polishing processes are hindered.

In CMP, there is a demand for a polishing agent capable of high-speed polishing on a silicon nitride film so as to polish a silicon oxide film and a silicon nitride film at the same speed while maintaining a sufficiently high polishing speed.

The present invention has been made in view of such circumstances and is directed to providing a cerium oxide and a polishing agent capable of high-speed polishing on a silicon nitride film.

### Solution to Problem

A first embodiment of a cerium oxide according to the present invention has, in a temperature programmed desorption measurement of CO₂ performed with use of oxygen and carbon monoxide, at least one peak of a CO₂ desorption amount within a range of 700°C or higher.

A second embodiment of a cerium oxide according to the present invention has, in a temperature programmed desorption measurement of CO₂ performed with use of oxygen and carbon monoxide, a total desorption amount of CO₂ of no smaller than 35 µmol/g.

A third embodiment of a cerium oxide according to the present invention has, in a temperature programmed desorption measurement of CO₂ performed with use of oxygen and carbon monoxide, a ratio (S/T) of a total desorption amount (S) of CO₂ in a temperature range of 600°C or higher to a total desorption amount (T) of CO₂ of no lower than 0.3.

A fourth embodiment of a cerium oxide according to the present invention is a particle having a true density of 5.0-6.8 g/cm³.

The cerium oxide above may include one or more metals selected from the group consisting of an alkaline-earth metal and a lanthanoid (excluding cerium).

The cerium oxide above may include the metal in 1-20 mol%.

In the cerium oxide above, the lanthanoid may include lanthanum.

In the cerium oxide above, the alkaline-earth metal may include one or more selected from the group consisting of barium and strontium.

The cerium oxide including the metal above may have a value obtained by subtracting a lattice constant of a cerium oxide that does not include the metal from a lattice constant of a cerium oxide that includes the metal of 0.001-0.05 Å.

A polishing agent according to the present invention includes the cerium oxide above and water.

### Advantageous Effects of Invention

The present invention provides a cerium oxide and a polishing agent capable of high-speed polishing on a silicon nitride film.

### Brief Description of Drawings

Fig. 1A is a sectional view illustrating one example of a semiconductor substrate to be polished through CMP in STI, taken before polishing.
Fig. 1B is a sectional view illustrating one example of a semiconductor substrate to be polished through CMP in STI, taken after polishing.
Fig. 2A is a sectional view illustrating another example of a semiconductor substrate.
Fig. 2B is a sectional view illustrating one example of the semiconductor substrate illustrated in Fig. 2A, taken after polishing.
Fig. 3 is a graph illustrating a profile of a temperature increase in CO-TPD.
Fig. 4 shows schematic diagrams each illustrating a state of a cerium oxide held in the steps shown in Fig. 3. Fig. 4A is a schematic diagram illustrating an initial state of the cerium oxide.
Fig. 4B is a schematic diagram illustrating a cerium oxide in which oxygen has been supplied to an oxygen vacancy.
Fig. 4C is a schematic diagram illustrating a cerium oxide to which carbon monoxide has been adsorbed.
Fig. 4D is a schematic diagram illustrating a cerium oxide from which carbon dioxide has been desorbed.
Fig. 5 shows; a temperature programmed desorption spectrum obtained in Example 4.
Fig. 6 is a schematic diagram illustrating one example of a polishing apparatus.

### Description of Embodiments

Some embodiments of the present invention will be described below. The present invention is not limited to the following embodiments, and any other embodiments may belong to the scope of the present invention as long as such embodiments match the spirit of the present invention.

The term "surface to be polished" as used according to the present invention refers to the surface of a polishing target that is to be polished and means, for example, an outer surface. In the present description, an intermediate-step surface that appears on a semiconductor substrate in the process of manufacturing a semiconductor device is also encompassed by the "surface to be polished."

"Silicon oxide" as used according to the present invention is specifically silicon dioxide. "Silicon oxide," however, is not limited to silicon dioxide and also includes any silicon oxides other than silicon dioxide.

The term "selection ratio" as used according to the present invention refers to the ratio (R_{SiO2}/R_{SiN}) of the polishing speed (R_{SiO2}) on a silicon oxide film to the polishing speed (R_{SiN}) on a silicon nitride film.

The symbol "-" indicating a numerical range means that the range includes the numerical values preceding and following the symbol as the lower limit and the upper limit.

### [CO-TPD]

First, a temperature programmed desorption measurement of CO₂ (CO-TPD) performed with use of oxygen and carbon monoxide for identifying a cerium oxide according to the present invention (may also be referred to below as the present cerium oxide) will be described.

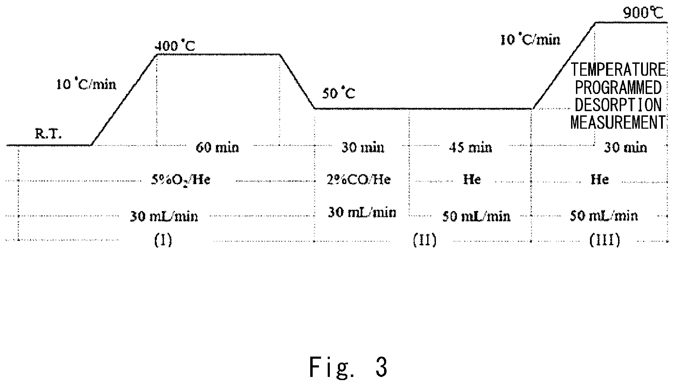

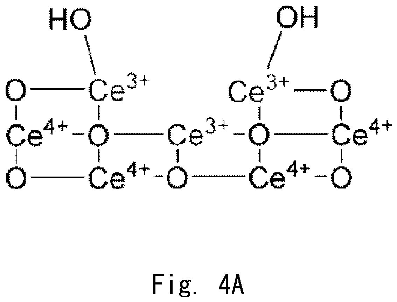

CO-TPD can be performed with reference to and in compliant with Non Patent Literature 2 described above. Specific description will be provided with reference to Fig. 3 and Figs. 4A to 4D. Fig. 3 is a graph illustrating a profile of a temperature increase in CO-TPD including pretreatment. Meanwhile, Figs. 4A to 4D are schematic diagrams illustrating the state of the cerium oxide in the respective steps.

In the present measurement, the temperature inside the furnace and the gas atmosphere are adjusted sequentially in accordance with the following steps (I) to (III), as illustrated Fig. 3. Herein, each step can be controlled automatically with a temperature programmed desorption measurement apparatus.

Step (I): About 100 mg of a cerium oxide to be measured is weighed and placed into a furnace, and the temperature inside the furnace is raised to 400°C at a heating rate of 10°C/min and held for 60 minutes, while 5-vol% oxygen is flowed into the furnace at a flow rate of 30 mL/min.

Step (II): The temperature inside the furnace is brought to 50°C, and then the temperature is held for 30 minutes while 2-vol% carbon monoxide is flowed into the furnace at a flow rate of 30 mL/min, and then held for 45 minutes while helium is flowed into the furnace at a flow rate of 50 mL/min.

Step (III): The temperature inside the furnace is raised to 900°C at a heating rate of 10°C/min and held for 30 minutes, while helium is flowed into the furnace at a flow rate of 50 mL/min, and thus a temperature programmed desorption spectrum is obtained.

Herein, the steps (I) to (III) are a preparation stage, and the gas component may be measured at least during the step (III). The gas component can be detected, for example, with a quadrupole mass spectrometer or the like.

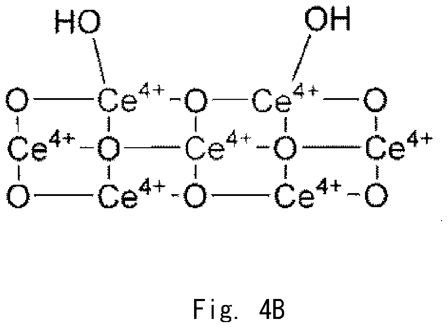

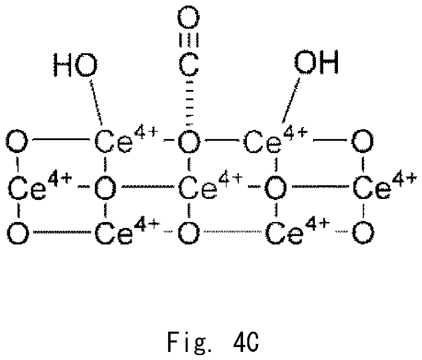

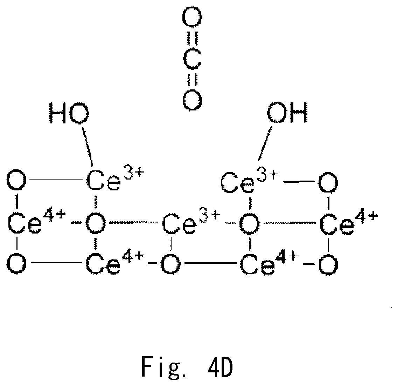

As illustrated in Fig. 4A, the cerium oxide, in the initial state, is estimated to have an oxygen vacancy in a part of its surface. Oxygen is supplied to this oxygen vacancy through the step (I), and the cerium oxide is estimated to have its oxygen vacancy reduced, as illustrated in Fig. 4B. Then, through the step (II), carbon monoxide is estimated to become adsorbed onto an oxygen atom mainly on the surface of the cerium oxide, as illustrated in Fig. 4C. The pretreatment for the present measurement completes at this point. Then, the temperature is raised as described above in the step (III); thus, carbon dioxide becomes desorbed, as illustrated in Fig. 4D, and a temperature programmed desorption spectrum of CO₂ is obtained.

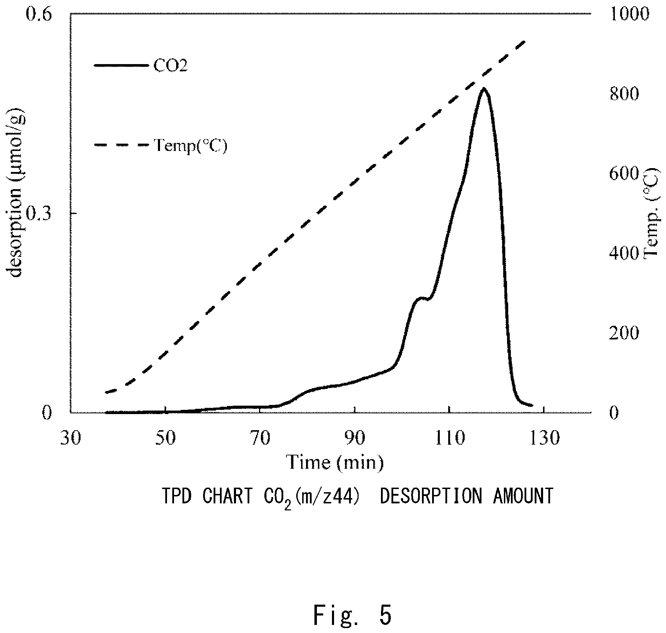

Fig. 5 shows an example of the temperature programmed desorption spectrum obtained in Example 4 of the examples described later. In the spectrum shown in Fig. 5, the horizontal axis represents the elapsed time (minutes), but this can be changed, as appropriate, to the temperature with use of the temperature curve (dashed line). Meanwhile, the vertical axis represents the desorption amount (µmol/g) of CO₂ per gram of the cerium oxide.

Examples of a method of detecting a peak from the obtained temperature programmed desorption spectrum include a method in which a peak is isolated through a known technique after multipoint baseline correction. Examples of a method of isolating a peak include vertical partition or waveform separation. In a case where vertical partition is used, the spectrum is partitioned by a line perpendicular to the horizontal axis at each trough (temperature) between peaks, and the range of each peak is determined. In a case where waveform separation is used, the Gauss function, the Lorentz function, the Voigt function, or the like can be used. In the case of waveform separation, with an assumption that there are, for example, one to five peaks, fitting is performed with the peak position (temperature), the half width, and the area (desorption amount) serving as parameters. In a case where waveform separation is performed, if desorption temperature peaks are close to one another (about 20°C as one criterion), the peaks may be treated as a single peak without being separated from one another. Whether to use vertical partition or waveform separation can be determined as desired; yet, peak isolation through waveform separation is preferable since some peaks may not be picked out in vertical partition.

The desorption amount of CO₂ can be obtained from the temperature programmed desorption spectrum based on an integrated value (area value) of the temperature programmed desorption spectrum.

For example, the total desorption amount of CO₂ indicates the integrated value of the segment of the temperature programmed desorption spectrum that corresponds to the total segment of the step (III) described above, and the total desorption amount of CO₂ in the temperature range of 600°C or higher indicates the integrated value of the segment of the temperature programmed desorption spectrum that spans from the time corresponding to 600°C to the time at which the temperature has been raised to 900°C and held for 30 minutes.

In the temperature programmed desorption measurement, the desorption temperature can vary somewhat by a difference between apparatuses (the presence or absence of a vacuum system within a flow in which a desorption gas is detected). As to the peak area (desorption amount), since the concentration of gas taken into a mass spectrometer can be changed by changing the lift of the flow rate valve within the mass spectrometer, the peak area (desorption amount) may somewhat vary depending on the setting of the lift. In order to prevent the measurement accuracy from decreasing due to the issues described above, if, with use of a hexahedral cerium oxide whose 100 plane is exposed obtained, for example, through a hydrothermal synthesis technique described in Non Patent Literature 1 described above, a measurement is performed based on this cerium oxide, then, comparison can be made with high accuracy even with different apparatuses or different apparatus settings.

The characteristics of the cerium oxide, such as the peak temperature of the CO₂ desorption amount or the desorption amount of CO₂, are determined by analyzing the temperature programmed desorption spectrum obtained after the baseline correction and the waveform separation described above. The total desorption amount (T) of CO₂ is obtained from the area of the temperature programmed desorption spectrum. Meanwhile, the total desorption amount (S) of CO₂ in the temperature range of 600°C or higher is obtained from the area of the temperature programmed desorption spectrum that corresponds to the period past the time corresponding to 600°C in the temperature programmed desorption spectrum.

### [Cerium Oxide]

The present cerium oxide satisfies one or more selected from (A) to (D) below.
(A): In CO-TPD described above, the cerium oxide has at least one peak of a CO₂ desorption amount within the range of 700°C or higher.
(B): In CO-TPD described above, the cerium oxide has a total desorption amount of CO₂ of no smaller than 35 µmol/g.
(C): In CO-TPD described above, the cerium oxide has a ratio (S/T) of the total desorption amount (S) of CO₂ in the temperature range of 600°C or higher to the total desorption amount (T) of CO₂ of no lower than 0.3
(D): The cerium oxide is a particle having a true density of 5.0-6.8 g/cm³.

A polishing agent that includes this cerium oxide in the form of abrasive grains has a high polishing speed on a silicon nitride film, and this, for example, makes it possible to polish a silicon oxide film and a silicon nitride film at the same speed while maintaining a sufficiently high polishing speed.

Although the mechanism that makes the above cerium oxide excel in polishability on a silicon nitride film is not yet fully understood, a cerium oxide that satisfies (B) above is speculated to have more oxygen vacancies serving as active points in its surface and to thus have a greater interaction with a surface to be polished. Meanwhile, a cerium oxide that satisfies (A) or (C) above is speculated to be more likely to form a strong bond since CO₂ is not desorbed till it reaches high temperature. Based on these results, it is speculated that the chemical interaction with silicon nitride, or a surface to be polished, increases, and thus the polishing speed on silicon nitride improves.

The present inventors have found that the polishing speed on silicon nitride improves with a cerium oxide whose true density satisfies (D) above. The true density of a cerium oxide that satisfies (D) will be described.

A density encompasses a true density, an apparent density, a bulk density, and so on. The true density is defined as a density in which the volume of a substance alone serves as a volume for calculating the density. Known methods of measuring the true density include a liquid displacement method and a gas displacement method. The apparent density is defined as a density in which the volume of a substance and any air gap inside the substance serves as a volume for calculating the density. In reality, in addition to the above, the volume of a space in a rugged portion on the surface of a particle that is not wetted by liquid is also included in the volume for calculating the density. Known methods of measuring the apparent density include the Le Chatelier flask method, the buoyancy weighing method, the Archimedes' method, or the mercury porosimetry. The bulk density is defined as a density in which a volume of a substance, any air gap inside the substance, and fine apertures serves as a volume for calculating the density. In reality, in addition to the above, the volume of a space in a rugged portion on the surface of a particle, a volume of any air gap between particles, and a volume of any air gap between a particle and a receptacle are also included in the volume for calculating the density. Known methods of measuring the bulk density include a container method and a funnel method.

According to the present invention, the density is defined as the true density. According to the present invention, the true density is measured through a gas displacement method. A gaseous phase displacement method can be considered to be the optimal method for measuring the density of an aggregate of particles having a size of several tens of nanometers, because as gas serves as a probe in the gaseous phase displacement method, as oppose to a liquid phase displacement method in which liquid serves as a probe, a tiny space between particles or in an aperture in the surface of a particle, such as a closed pore, can be more easily reflected on the volume for measuring the density.

The present cerium oxide has a density measured through a gaseous phase displacement method with He serving as a probe of, that is, a true density of preferably no smaller than 5.0 g/cm³ nor greater than 6.8 g/cm³. The true density is preferably no smaller than 5.5 g/cm³ nor greater than 6.7 g/cm³ or more preferably no smaller than 6.0 g/cm³ nor greater than 6.6 g/cm³. When the true density is no greater than 6.8 g/cm³, even when a hard film, such as a silicon nitride film, is polished at a high speed, any scratches produced in the silicon nitride film can be minimized. As the true density is no smaller than 5.0 g/cm³, scratches produced in a silicon oxide film or the like can be minimized while maintaining a desired polishing rate on the silicon oxide film.

The value of the true density of the present cerium oxide is much smaller than 7.215 g/cm³, the documented value of the density of cerium oxide. Estimated main factors that can keep the true density of the present cerium oxide much lower include (1) a lattice defect, that is, an oxygen vacancy; and (2) a difference in the atomic weight resulting from the replacement of a metallic element different from cerium. Since the true density of the present cerium oxide is even lower than the theoretical value that takes both (1) and (2) into consideration, the presence of other factors can be speculated.

From the standpoint of polishing a silicon nitride film at a higher speed, it is preferable that the present cerium oxide satisfy one or more selected from (A) to (C) above, and it is more preferable that the present cerium oxide satisfy all of (A) to (C) above.

The cerium oxide may be composed of cerium and oxygen and may further include other atoms. From the standpoint of ease of satisfying one or more selected from the group consisting of (A) to (D) above, the cerium oxide preferably contains a metal selected from an alkaline-earth metal and a lanthanoid excluding cerium.

Examples of such an alkaline-earth metal include beryllium, magnesium, calcium, strontium, barium, and radium, and from the standpoint of polishability of silicon nitride, strontium or barium is preferable.

Examples of a lanthanoid include lanthanum, praseodymium, neodymium, promethium, samarium, europium, gadolinium, terbium, dysprosium, holmium, erbium, thulium, ytterbium, and lutetium, and from the standpoint of polishability of silicon nitride, lanthanum is preferable.

These metals may each be used singly, or two or more of these metals may be used in combination.

In the present cerium oxide, the content ratio of the above metal is preferably 1-20 mol% with respect to the total amount of the present cerium oxide including the metal and so on, or more preferably 1-18 mol%.

Next, a lattice constant (a) of a cerium oxide that includes a metal selected from the alkaline-earth metals and the lanthanoids, excluding cerium, listed above will be described.

According to the present invention, the lattice constant is determined by a pattern obtained through a powder X-ray diffraction measurement and an assigned Miller index (hkl). The following can be determined based on a value (Δa = a1 - a0) obtained by subtracting a lattice constant (a0) of a cerium oxide that does not contain metal from a lattice constant (a1) of a cerium oxide that contains metal. Specifically, when the value of Δa is positive, this indicates that an ion having a radius greater than the ionic radius of a cerium ion is incorporated into the lattice of the cerium oxide, and thus the lattice has extended. Meanwhile, when the value of Δa is negative, this indicates that an ion having a radius smaller than the ionic radius of a cerium ion is incorporated into the lattice of the cerium oxide, and thus the lattice has contracted. Moreover, as the absolute value of Δa is greater, this means that an ion having a radius far from the ionic radius of a cerium ion is incorporated into the lattice or that a large amount of ions are incorporated into the lattice. In this manner, how different elements are incorporated into the lattice can be determined based on Δa.

Δa is preferably 0.001-0.05 Å or more preferably 0.002-0.035 Å. When Δa is within these ranges, a high polishing speed on a silicon nitride film can be obtained.

The present cerium oxide may further include other atoms within a range that can still provide the advantageous effects of the present invention. Examples of such atoms include fluorine, carbon, nitrogen, aluminum, and silicon. From the standpoint of polishability of silicon nitride, these other atoms are contained preferably in no greater than 5 mol% or more preferably in no greater than 1 mol% with respect to the total amount of the cerium oxide.

In particular, fluorine atoms may increase the hardness of the cerium oxide to scratch the polishing surface, and thus the content ratio of fluorine atoms is preferably no greater than 1 mol% or more preferably no greater than 0.1 mol% with respect to the total amount of the cerium oxide.

The mean particle size of the cerium oxide particles is preferably 0.01-0.5 µm or more preferably 0.03-0.3 µm. If the mean particle size exceeds 0.5 µm, polish scrapes, such as scratches, may occur in a surface to be polished. Meanwhile, if the mean particle size is smaller than 0.01 µm, the polishing speed may decrease.

Since the cerium oxide particles are present in liquid in the form of aggregate particles (secondary particles) in which primary particles have aggregated, a preferred particle size of the cerium oxide particles is expressed by a mean secondary particle size. In other words, the mean particle size indicated by the numerical ranges above is normally a mean secondary particle size. The mean secondary particle size is measured by a particle size distribution meter of a laser diffraction/scattering system or the like with use of a dispersion in which the particles are dispersed in a dispersion medium, such as pure water.

Although there is no particular limitation on the crystal structure of the cerium oxide, from the standpoint of polishability, a cubic fluorite structure is preferable. According to the manufacturing method described below, a cerium oxide having a cubic fluorite structure can be obtained.

### [Method of Manufacturing Cerium Oxide]

Any method of manufacturing the present cerium oxide can be selected from methods that yield a cerium oxide that satisfies one or more selected from (A) to (D) above.

As one example of such manufacturing methods, a manufacturing method that includes the following steps 1 to 3 (also referred to below as the present manufacturing method) can be illustrated.

Specifically, the present manufacturing method includes the following steps 1 to 3.

Step 1: A step of adding an aqueous solution containing a dopant that includes one or more metals selected from the group consisting of an alkaline-earth metal and a lanthanoid (excluding cerium) to a slurry in which a compound containing poorly soluble cerium is dispersed.

Step 2: A step of drying the slurry and causing the dopant to adhere to the surface of the compound containing the cerium.

Step 3: A step of calcining the compound containing the cerium to which the dopant has adhered.

According to the present manufacturing method, a cerium oxide that satisfies one or more selected from the group consisting of (A) to (D) above can be synthesized favorably. Each of the steps will be described below.

In the present manufacturing method, first, each of a slurry in which a compound containing poorly soluble cerium is dispersed and an aqueous solution containing a dopant that includes one or more metals selected from the group consisting of an alkaline-earth metal and a lanthanoid is prepared.

Examples of poorly soluble cerium include cerium oxide, cerium carbonate, cerium hydroxide, cerium sulfate, cerium phosphate, cerium oxalate, and cerium carbonate hydroxide. A dispersion medium for poorly soluble cerium is normally water.

The aqueous solution is an aqueous solution in which the specific metal is dissolved. Examples of a water-soluble compound containing the metal include a nitrate, a carbonate, an acetate, a sulfate, an oxalate, a chloride, a hydroxide, and a halide. The aqueous solution may have its pH or the like adjusted. For example, even a compound that is poorly soluble in water, such as an oxide, can also be used if that compound becomes soluble upon its pH or the like adjusted. Among the above, a compound that is highly soluble in water is preferable in the manufacturing process, and a compound in which a counteranion of a metallic element dissolves or volatilizes at low temperature is preferable from the standpoint of stability of polishing characteristics, in particular, of the polishing rate. Examples of compounds that satisfy such characteristics include an oxalate and an acetate. An aqueous solution in which, for example, a carbonate and an organic acid are dissolved or an aqueous solution in which a hydroxide and an organic acid are dissolved is also suitable.

After the slurry and the aqueous solution have been prepared, the aqueous solution is added to the slurry. The aqueous solution may be added at room temperature or at an elevated temperature.

Next, the slurry is dried. Any desired drying method can be selected from methods for evaporating moisture. For example, the slurry may be heated with a heater or in a furnace, heated in a warm bath, or sprayed with dry air. From the standpoint of causing the dopant to adhere uniformly onto the surface of the compound containing the cerium, the slurry is preferably stirred during the drying step. The slurry is dried in the present drying step.

The compound that contains the cerium and to which the dried dopant has adhered is pulverized, as necessary, and heated and calcined. From the standpoint of crystallinity, the heating temperature is preferably no lower than 500°C, more preferably no lower than 600°C, or even more preferably no lower than 700°C. Meanwhile, although there is no particular limitation on the upper limit of the heating temperature, the heating temperature is normally no higher than 1000°C, and from the standpoint of suppressing an increase in the coarse particles, the heating temperature is preferably no higher than 950°C or more preferably no higher than 900°C.

Herein, in a case where a large amount of Sr or Ba is used as an alkaline-earth metal, the obtained cerium oxide may contain, as an impurity, strontium carbonate or barium carbonate. In this case, the carbonate can be removed by washing the cerium oxide with an aqueous acid solution whose pH has been adjusted to around 2, such as a hydrochloric acid or a nitric acid aqueous solution, as necessary.

A cerium oxide obtained through the manufacturing method described above satisfies at least one of the characteristics ((A) to (C) above) of the present cerium oxide.

### <Use of Cerium Oxide>

The present cerium oxide can be used suitably as abrasive grains in a polishing agent for use, for example, in CMP, or in particular in STI. Since the present cerium oxide helps improve the polishing speed on a silicon nitride surface, in particular in CMP of a surface to be polished including a silicon oxide surface and a silicon nitride surface, the silicon oxide surface and the silicon nitride surface can be polished at the same speed while a decrease in the polishing speed is suppressed.

When the present cerium oxide is used as a polishing agent, the present cerium oxide is preferably used with the particles of the present cerium oxide dispersed in a dispersion medium. The dispersion medium may be selected, as appropriate, from liquid in which the present cerium oxide is insoluble or poorly soluble. In use in CMP, water is in particular preferable as a dispersion medium. A polishing agent containing the present cerium oxide may contain a known additive, as appropriate and as necessary.

There is no particular limitation on such an additive, and examples of the additive include a polymer, a pH regulator, and a chelating agent that adjust the polishing rate on a silicon oxide film or a silicon nitride film.

As the pH regulator, any one selected, as appropriate, from known inorganic acids, organic acids, basic compounds, amphoteric compounds such as amino acids, and salts thereof can be used.

Examples of the inorganic acids include a nitric acid, a sulfuric acid, a hydrochloric acid, and a phosphoric acid, and an ammonium salt, a sodium salt, a potassium salt, or the like thereof may be used.

Examples of the organic acids include carboxylic acids such as a picolinic acid, organic sulfonic acids, and organic phosphoric acids, and an ammonium salt, a sodium salt, a potassium salt, or the like thereof may be used. Examples of the organic basic compounds include, as basic compounds, compounds containing nitrogen, such as ammonia, potassium hydroxide, tetramethylammonium hydroxide, or ethylene diamine.

Examples of the amphoteric compounds include glycine, alanine, and phenylalanine.

For the chelating agent, any chelating agent can be selected, as appropriate, from those known to be used for polishing agents, and examples include a dicarboxylic acid-based chelating agent, a tricarboxylic acid-based chelating agent, a gluconic acid-based chelating agent, a nitrilotriacetic acid-based chelating agent, and an iminosuccinic acid-based chelating agent.

Examples of a method of polishing with use of a polishing agent containing the present cerium oxide include a method in which a polishing pad is bought into contact with a surface to be polished of a polishing target while the polishing agent is supplied, and the surface to be polished is polished through the relative motion of the surface to be polished and the polishing pad. Herein, examples of the surface to be polished include a surface of a semiconductor substrate on which a silicon dioxide film and silicon nitride are arranged in a pattern.

When silicon nitride is polished with use of a polishing agent containing the present cerium oxide, it is preferable that a silicon nitride film, a polysilicon film, or the like be provided as a base film. Since the present cerium oxide has a low polishing rate on such a base film, a flattened surface where the base film is exposed to the surface is formed.

Examples of a silicon dioxide film in an STI substrate include what is known as a PE-TEOS film, which is deposited through a plasma CVD technique with a tetraethoxysilane (TEOS) serving as a source material. Other examples of a silicon dioxide film include what is known as an HDP film, which is deposited through a high-density plasma CVD technique. A HARP film or an FCVD film deposited through other CVD techniques or a SOD film formed through spin coating can also be used. Examples of a silicon nitride film include a film deposited through a low-pressure CVD technique or a plasma CVD technique or a film deposited through an ALD technique, with silane or dichlorosilane and ammonia serving as source materials.

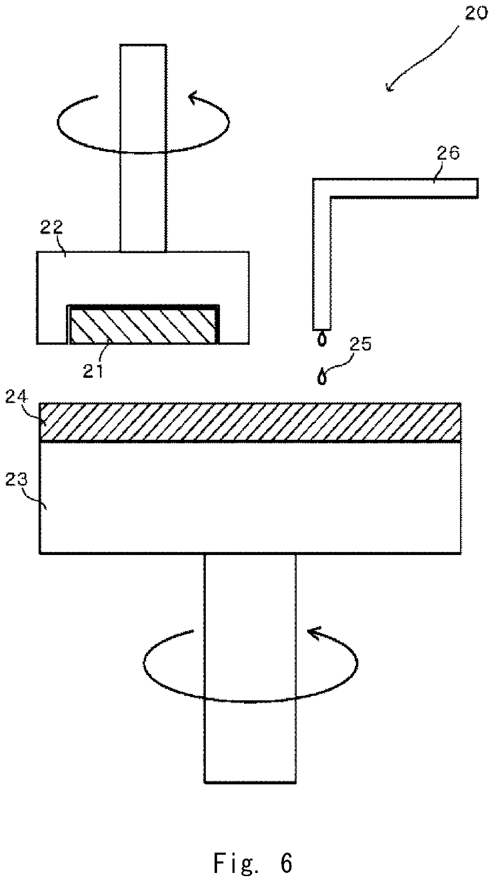

Any known polishing apparatus can be used in the polishing method according to the present embodiment. Fig. 6 is a schematic diagram illustrating one example of a polishing apparatus. A polishing apparatus 20 of the example shown in Fig. 6 includes a polishing head 22 that holds a semiconductor substrate 21, such as an STI substrate; a polishing platen 23; a polishing pad 24 affixed to a surface of the polishing platen 23; and a polishing agent feeding pipe 26 that feeds a polishing agent 25 to the polishing pad 24. While the polishing agent 25 is fed from the polishing agent feeding pipe 26, a surface to be polished of the semiconductor substrate 21 held by the polishing head 22 is brought into contact with the polishing pad 24, and the surface to be polished is polished with the polishing head 22 and the polishing platen 23 each undergoing a rotary motion relative to each other.

The polishing head 22 may undergo not only the rotary motion but also a linear motion. The polishing platen 23 and the polishing pad 24 may have a size equivalent to or smaller than the size of the semiconductor substrate 21. In this case, it is preferable that the polishing head 22 and the polishing platen 23 be moved relative to each other, so that the entire surface of the surface to be polished of the semiconductor substrate 21 can be polished. The polishing platen 23 and the polishing pad 24 need not undergo a rotary motion and may move along one direction, for example, with a belt-like system.

Although there is no particular limitation on the polishing condition of such a polishing apparatus 20, if a load is exerted on the polishing head 22 to press the polishing head 22 against the polishing pad 24, the polishing pressure can be increased, and the polishing speed can thus be improved. The polishing pressure is preferably about 0.5-50 kPa, or is more preferably about 3-40 kPa from the standpoint of uniformity and flatness of the polishing speed within the surface to be polished of the semiconductor substrate 21 and from the standpoint of prevention of any polishing defect caused by a scratch or the like. The number of rotations of the polishing platen 23 and the polishing head 22 is preferably about 50-500 rpm. The feeding amount of the polishing agent 25 is adjusted, as appropriate, based on the composition of the polishing agent or the polishing condition or the like described above.

For the polishing pad 24, a polishing pad made of nonwoven fabric, polyurethane foam, porous resin, nonporous resin, or the like can be used. In order to facilitate the feeding of the polishing agent 25 to the polishing pad 24 or in order to pool a certain amount of the polishing agent 25 in the polishing pad 24, the surface of the polishing pad 24 may be grooved, for example, in a lattice pattern, in a concentric circular pattern, or in a spiral pattern. The polishing may be performed, as necessary, with a pad conditioner in contact with the surface of the polishing pad 24 and while the surface of the polishing pad 24 is conditioned.

### Examples

The present invention will be described in more concrete terms with examples and comparative examples below, but the present invention is not limited by these examples. In the following examples, "%" means mass%, unless specifically indicated otherwise. The characteristic values were measured and evaluated through the method described below. Examples 1 to 5 are examples of cerium oxides according to the present invention and methods of manufacturing the same, and Examples 6 to 8 are comparative examples.

### [Synthesis of Cerium Oxide]

### (Example 1): The present manufacturing method (also referred to below as a synthesis method A).

42.4 g of anhydride of cerium carbonate was charged into a firing furnace and calcined for 1 hour while air was blown into the firing furnace at 800°C. A slurry containing 31.7 g of powder of a cerium oxide obtained as described above was placed in an evaporating dish. Next, 8.834 g of lanthanum nitrate hexahydrate was dissolved in 40 mL of pure water. The evaporating dish having the slurry placed therein was placed on a hot stirrer, and the slurry was stirred with a stirrer with the temperature set at 200°C. Upon confirming that vapors started to rise from the evaporating dish, an aqueous solution of lanthanum nitrate was added bit by bit over about 3 minutes, and the slurry was completely dried while being stirred. The precursor in a mass form was pulverized in an agate mortar to a powder form, and this was calcined in an electric furnace. The calcining temperature was 800°C, and the calcining duration was 8 hours. The temperature was raised to 800°C over 2 hours, and the temperature was lowered through natural dissipation after the calcining. The obtained powder was pulverized in an agate mortar and washed with 300 mL of pure water. With use of a 0.1-µm membrane filter and a suction filtration device, the above resultant was washed with pure water until the pH of the filtrate approached being neutral, and particles were collected. The collected particles were dried for 12 hours in a thermostatic bath at 80°C, and the moisture was removed completely. The obtained powder was again pulverized in an agate mortar, and the cerium oxide of Example 1 was obtained.

### (Example 2)

The cerium oxide of Example 2 was obtained in a manner similar to that of Example 1, except that the amount of lanthanum nitrate hexahydrate was changed from that of Example 1 to 13.251 g.

### (Example 3)

The cerium oxide of Example 3 was obtained in a manner similar to that of Example 1, except that 4.317 g of strontium nitrate was used in place of lanthanum nitrate hexahydrate of Example 1.

### (Example 4)

The cerium oxide of Example 4 was obtained in a manner similar to that of Example 1, except that 2.665 g of barium nitrate was used in place of lanthanum nitrate hexahydrate of Example 1.

### (Example 5)

The cerium oxide of Example 5 was obtained in a manner similar to that of Example 1, except that 5.331 g of barium nitrate was used in place of lanthanum nitrate hexahydrate of Example 1.

### (Example 6): (Example in which no other metals are added in the synthesis method A. This method is also referred to below as a synthesis method AX.)

42.4 g of anhydride of cerium carbonate was charged into a firing furnace and calcined for 1 hour while air was blown into the firing furnace at 800°C. A slurry containing 31.7 g of powder of a cerium oxide obtained as described above was placed in an evaporating dish. The evaporating dish having the slurry placed therein was placed on a hot stirrer, and the slurry was dried completely while being stirred with a stirrer with the temperature set at 200°C. The precursor in a mass form was pulverized in an agate mortar to a powder form, and this was calcined in an electric furnace. The calcining temperature was 800°C, and the calcining duration was 8 hours. The temperature was raised to 800°C over 2 hours, and the temperature was lowered through natural dissipation after the calcining. The obtained powder was pulverized in an agate mortar and washed with 300 mL of pure water. With use of a 0.1-µm membrane filter and a suction filtration device, the above resultant was washed with pure water until the pH of the filtrate approached being neutral, and particles were collected. The collected particles were dried for 12 hours in a thermostatic bath at 80°C, and the moisture was removed completely. The obtained powder was again pulverized in an agate mortar, and the cerium oxide of Example 6 was obtained.

### (Example 7): Premixing method (also referred to below as a synthesis method B).

This is a method of obtaining a cerium oxide by dissolving a cerium source and a different element source material together in water at the time of a crystallization reaction (coprecipitation reaction) to obtain a precipitate (cerium oxide having a different element added thereto, cerium carbonate, or the like) and calcining the obtained precipitate. The cerium oxide of Example 7 was obtained through this method with use of cerium carbonate and lanthanum nitrate hexahydrate as source materials.

### (Example 8): Hydrothermal synthesis method (also referred to below as a synthesis method C).

A hexahedral cerium oxide whose 100 plane was exposed was synthesized through a hydrothermal synthesis technique with reference to Non Patent Literature 1. Specifically, an aqueous solution (precipitate) in which cerium nitrate and sodium hydroxide were mixed was charged into a tightly closed container, and a hydrothermal reaction was performed for 24 hours at 180°C. Thus, the cerium oxide of Example 8 was obtained. The obtained cerium oxide was washed sufficiently with pure water to remove any unreacted components, sodium, and nitric acid ions, and inductively coupled plasma optical emission spectrometry (ICP), a conductivity measurement, or the like confirmed that sodium, nitric acid ions, and so on had been washed off sufficiently.

For each of the cerium oxides obtained in Examples 1 to 8, the X-ray diffraction (XRD) was measured and evaluated with use of a high-speed X-ray diffractometer SmartLab manufactured by Rigaku Corporation. The measurement conditions were set as follows. X-ray tube: Cu, voltage: 40 kV, current: 200 mA, scan mode: Step Scan, measurement angle range: 10-150 degrees, sampling interval: 0.01 degrees, and scan duration per step: 2 s. Each obtained XRD profile was compared against a database (JCPDS No.: 34-0394) to confirm that a cerium oxide having a target cubic fluorite structure was obtained.

It was confirmed that, since the cerium oxides of Examples 1 to 5 and Example 7 contained La, Sr, or Ba, each peak shifted slightly to a smaller angle side. For the cerium oxides of Examples 1 and 2, no peak attributable to other than a cerium oxide containing La was confirmed.

For the cerium oxides of Examples 6 and 8, no peak shift was confirmed.

30 g of each of the cerium oxides obtained in Examples 1 to 8 was charged into a receptacle containing 270 mL of pure water, irradiated by an ultrasonic homogenizer for 5 minutes, and subjected to disintegration and dispersion treatment. Next, zirconia balls of 5 mmϕ were added so that the resulting volume became approximately equal to the volume of the pure water, and the resultant was subjected to ball mill pulverization for 30 minutes and to disintegration and dispersion treatment. Next, jet milling treatment was performed 5 times for disintegration and dispersion treatment, and thus slurries in which the respective cerium oxides of Examples 1 to 8 were dispersed were obtained.

Herein, in the various disintegration and dispersion treatments, nitric acid was added, as appropriate, as a pH regulator to achieve a pH of 3-5. For the homogenizer, US-600TCVP (apparatus name) manufactured by NIHONSEIKI KAISHA LTD. was used, and for a wettype jet mill, Star Burst Mini (apparatus name) manufactured by Sugino Machine Limited was used.

The mean secondary particle size D of the cerium oxide in each obtained slurry was measured with use of a laser scattering/diffraction apparatus (manufactured by HORIBA, Ltd., product name: LA-950). The measurement result is shown in Table 1.

### [Evaluation of Polishing Speed]

With use of the slurries of Examples 1 to 8 obtained as described above, the polishing speed on silicon nitride was measured. For a polisher, a fully automatic CMP apparatus (manufactured by Applied Materials, Inc., apparatus name: Mirra) was used. For a polishing pad, a double-layer pad (manufactured by DuPont, product name: IC-1000 K-groove) was used, and conditioning was performed with use of a diamond disk (manufactured by 3M, product name: A165). Then, silicon nitride was polished for 1 minute with the feeding speed of the slurry serving as the polishing agent set to 200 cm³/min, with the number of rotations of the polishing platen set to 77 rpm, and with the polishing pressure set to 3 psi.

The polishing speed was measured with use of an optical membrane thickness gauge (manufactured by KLA-Tencor, apparatus name: UV-1280SE). The evaluation was performed with the membrane thickness removal amount per minute regarded as the polishing rate (RR). With the polishing rate of Example 6 used as a reference (100), the polishing rate of each example was compared. The result is shown in Table 1.

### [CO-TPD]

In the temperature programmed desorption measurement (TPD), the evaluation was performed with use of a fully automatic temperature programmed desorption spectrometer TPD-1-ATw manufactured by MicrotracBEL Corp. About 100 g of each sample was collected, and the measurement was performed in accordance with a measurement program shown in Fig. 3. The details are as follows. In the temperature programmed desorption measurement, a target gas component was detected with a quadrupole mass spectrometer. With the measurement temperature range being 50-900°C, and with the measurement atmosphere being He 50 mL/min, a fragment of m/z 18,28,44 was detected. The obtained temperature programmed desorption spectrum was subjected to the baseline correction and the waveform analysis in accordance with the method described above, and (A) the maximum peak temperature, (B) the total desorption amount of CO₂, and (C) the ratio (S/T) of the total desorption amount (S) of CO₂ in a temperature range of 600°C or higher to the total desorption amount (T) of CO₂ were obtained. The result is shown in Table 1.

### [True Density]

The true density of each of the cerium oxides obtained in Examples 1 to 8 was measured and evaluated with use of AccuPyc II 1340 manufactured by Shimadzu Corporation. With a He gas used as a probe, the temperature of the circulating thermostatic bath was set to 25°C. Purging with a He gas was performed 30 times as pretreatment of the samples; then, the measurement was repeated 10 times, and the mean value from these 10 measurements was used as the true density. The purge charging pressure and the measurement charging pressure of the He gas into the measurement cell were 135 kPa, and the purging was terminated when a change in pressure became 0.05 kPa/min.

### [Table 1]

**Table 1**

| | Added Metal | Added Amount (mol%) | Synthesis Method | Temperature Programmed Desorption Measurement Result | | | Evaluation of Polishing Speed | | D50 (µm) | True Density (g/cm³) |
|---|---|---|---|---|---|---|---|---|---|---|
| | | | | (A) Peak Temperature (°C) | (B) Total Desorption Amount (µmol/g) | (C) Ratio of Desorption Amount (%) | SiN RR (Å/min) | SiN RR Improvement Rate (%) (Example 8 being 100) | | |
| Example 1 | La | 10 | Synthesis Method A | 706 | 37 | 21.4 | 733 | 102 | 0.087 | 6.76 |
| Example 2 | La | 15 | Synthesis Method A | 707 | 51 | 32.0 | 885 | 123 | 0.086 | 6.70 |
| Example 3 | Sr | 10 | Synthesis Method A | 795 | 466 | 95.1 | 1130 | 157 | 0.110 | 6.41 |
| Example 4 | Ba | 5 | Synthesis Method A | 801 | 140 | 80.8 | 1044 | 145 | 0.116 | 6.65 |
| Example 5 | Ba | 10 | Synthesis Method A | 848 | 473 | 94.9 | 1.373 | 191 | 0.110 | 6.58 |
| Example 6 | None | - | Synthesis Method AX | 554 | 12 | 17.1 | 660 | 92 | 0.088 | 6.99 |
| Example 7 | La | - | Synthesis Method B | 698 | 30 | 25.9 | 692 | 96 | 0.082 | 6.81 |
| Example 8 | None | - | Synthesis Method C | 584 | 25 | 8.1 | 719 | 100 | 0.220 | 7.05 |

As shown in Table 1, as for the present cerium oxide, the cerium oxides of Examples 1 to 5 that satisfy one or more selected from (A) to (D) below exhibited a high polishing speed on a silicon nitride film.
(A): The cerium oxide has at least one peak of a CO₂ desorption amount within the range of 700°C or higher.
(B): The cerium oxide has a total desorption amount of CO₂ of no smaller than 35 µmol/g.
(C): The cerium oxide has a ratio (S/T) of the total desorption amount (S) of CO₂ in the temperature range of 600°C or higher to the total desorption amount (T) of CO₂ of no lower than 0.3.
(D): The cerium oxide is a particle having a true density of 5.0-6.8 g/cm³.

### [Evaluation of Lattice Constant]

For each of the cerium oxides of Examples 1 to 7 obtained as described above, the lattice constant (a) was obtained from a pattern obtained in the powder X-ray diffraction measurement and the assigned Miller index (hkl). The powder X-ray diffraction was evaluated with use of a high-speed X-ray diffractometer SmartLab manufactured by Rigaku Corporation. The measurement conditions were set as follows. X-ray tube: Cu, voltage: 40 kV, current: 200 mA, scan mode: Step Scan, measurement angle range: 10-150 degrees, sampling interval: 0.01 degrees, and scan duration per step: 2 s. Each obtained XRD profile was compared against a database (JCPDS No.: 34-0394) to confirm that a cerium oxide having a target cubic fluorite structure was obtained.

Then, a value (Δa) obtained by subtracting the lattice constant of the cerium oxide (Example 6) that does not contain metal from the lattice constant of the cerium oxides (Examples 1 to 5 and 7) that each contain metal was calculated. These results are shown in Table 2.

### [Table 2]

**Table 2**

| Examples | a (A) | Δa (A) |
|---|---|---|
| 1 | 5.43705 | 0.02391 |
| 2 | 5.43825 | 0.02511 |
| 3 | 5.42177 | 0.00863 |
| 4 | 5.41585 | 0.00272 |
| 5 | 5.41812 | 0.00498 |
| 6 | 5.41314 | 0 |
| 7 | 5.44868 | 0.03555 |

Based on the results shown in Tables 1 and 2, the cerium oxides of Examples 1 to 5 satisfied one or more selected from (A) to (D) above, as a metal ion having an ionic radius greater than the ionic radius of a cerium ion was incorporated sufficiently into the lattice, and thus a high polishing speed on a silicon nitride film was obtained. In contrast, the cerium oxide of Example 6 in which no metal ion was added and the cerium oxide of Example 7 manufactured through the synthesis method B failed to satisfy one or more selected from (A) to (D) above, and thus a high polishing speed on a silicon nitride film was not obtained.

This application claims priority to Japanese Patent Application No. 2020-164640, filed on September 30, 2020, the entire disclosure of which is incorporated herein.
- 1: SILICON SUBSTRATE
- 2: SILICON NITRIDE FILM
- 3: TRENCH
- 4: SILICON DIOXIDE FILM
- 5: TITANIUM NITRIDE FILM
- 20: POLISHING APPARATUS
- 21: SEMICONDUCTOR SUBSTRATE
- 22: POLISHING HEAD
- 23: POLISHING PLATEN
- 24: POLISHING PAD
- 25: POLISHING AGENT
- 26: POLISHING AGENT FEEDING PIPE

## Claims

1. A cerium oxide, wherein in a temperature programmed desorption measurement of CO₂ performed with use of oxygen and carbon monoxide, the cerium oxide has at least one peak of a CO₂ desorption amount within a range of 700°C or higher.

2. A cerium oxide, wherein in a temperature programmed desorption measurement of CO₂ performed with use of oxygen and carbon monoxide, the cerium oxide has a total desorption amount of CO₂ of no smaller than 35 µmol/g.

3. A cerium oxide, wherein in a temperature programmed desorption measurement of CO₂ performed with use of oxygen and carbon monoxide, the cerium oxide has a ratio (S/T) of a total desorption amount (S) of CO₂ in a temperature range of 600°C or higher to a total desorption amount (T) of CO₂ of no lower than 0.3.

4. A cerium oxide, wherein the cerium oxide is a particle having a true density of 5.0-6.8 g/cm³.

5. The cerium oxide according to any one of Claims 1 to 4, wherein the cerium oxide includes one or more metals selected from the group consisting of an alkaline-earth metal and a lanthanoid (excluding cerium).

6. The cerium oxide according to Claim 5, wherein the cerium oxide includes the metal in 1-20 mol%.

7. The cerium oxide according to Claim 5 or 6, wherein the lanthanoid includes lanthanum.

8. The cerium oxide according to any one of Claims 5 to 7, wherein the alkaline-earth metal includes one or more selected from the group consisting of barium and strontium.

9. The cerium oxide according to any one of Claims 5 to 8, wherein the cerium oxide has a value obtained by subtracting a lattice constant of a cerium oxide that does not include the metal from a lattice constant of a cerium oxide that includes the metal of 0.001-0.05 Å.

10. A polishing agent comprising:
a cerium oxide; and
water,
wherein in a temperature programmed desorption measurement of CO₂ performed with use of oxygen and carbon monoxide, the cerium oxide has at least one peak of a CO₂ desorption amount within a range of 700°C or higher.

11. A polishing agent comprising:
a cerium oxide; and
water,
wherein in a temperature programmed desorption measurement of CO₂ performed with use of oxygen and carbon monoxide, the cerium oxide has a total desorption amount of CO₂ of no smaller than 35 µmol/g.

12. A polishing agent comprising:
a cerium oxide; and
water,
wherein in a temperature programmed desorption measurement of CO₂ performed with use of oxygen and carbon monoxide, the cerium oxide has a ratio (S/T) of a total desorption amount (S) of CO₂ in a temperature range of 600°C or higher to a total desorption amount (T) of CO₂ of no lower than 0.3.
